(19) Europäisches Patentamt

European Patent Office

Office européen des brevets

(11) Veröffentlichungsnummer: **0 214 677 B1**

(12) **EUROPÄISCHE PATENTSCHRIFT**

(45) Veröffentlichungstag der Patentschrift: **02.01.92**

(21) Anmeldenummer: **86201316.6**

(22) Anmeldetag: **24.07.86**

Teilanmeldung 89108452.7 eingereicht am 24/07/86.

(51) Int. Cl.⁵: **G11B 7/08**

(54) **Optische Abtasteinheit.**

(30) Priorität: **14.08.85 DE 3529090**
**14.08.85 DE 3529091**
**25.11.85 NL 8503238**

(43) Veröffentlichungstag der Anmeldung:
**18.03.87 Patentblatt 87/12**

(45) Bekanntmachung des Hinweises auf die Patenterteilung:
**02.01.92 Patentblatt 92/01**

(84) Benannte Vertragsstaaten:
**DE FR GB IT NL**

(56) Entgegenhaltungen:
**EP-A- 0 012 650**    **EP-A- 0 103 929**
**EP-A- 0 133 994**    **EP-A- 0 143 483**
**EP-A- 0 178 719**    **FR-A- 2 521 377**

**PATENTS ABSTRACTS OF JAPAN, Band 8, Nr. 82 (P-268)[1519], 14. April 1984; & JP-A-59 109 (MAMIYA KOUKI K.K.) 05-01-1984**

**PATENTS ABSTRACTS OF JAPAN, Band 9, Nr. 9 (P-327)[1732], 16. Januar 1985; & JP-A-59 159 113 (MAMIYA KOUKI K.K.) 08-09-1984**

(73) Patentinhaber: **Philips Patentverwaltung GmbH**
**Wendenstrasse 35 Postfach 10 51 49**
**W-2000 Hamburg 1(DE)**

(84) Benannte Vertragsstaaten:
**DE**

Patentinhaber: **N.V. Philips' Gloeilampenfabrieken**
**Groenewoudseweg 1**
**NL-5621 BA Eindhoven(NL)**

(84) Benannte Vertragsstaaten:
**FR GB IT NL**

(72) Erfinder: **Meyer, Karl-Hans, Dr.**
**Nerscheider Weg 34**
**W-5100 Aachen(DE)**
Erfinder: **Honds, Leo**
**Flandrische Strasse 50**
**W-5100 Aachen(DE)**
Erfinder: **Gijzen, Wilhelmus c/o Int. Octrooibureau B.V.**
**Prof. Holstlaan 6**
**NL-5656 AA Eindhoven(NL)**

EP 0 214 677 B1

EP 0 214 677 B1

PATENTS ABSTRACTS OF JAPAN, Band 8, Nr. 86 (P-269)[1523], 19. April 1984; & JP-A-59 2238 (FUJITSU K.K.) 07-01-1984

PATENTS ABSTRACTS OF JAPAN, Band 7, Nr. 150 (P-207)[1295], 30. Juni 1983; & JP-A-58 60 434 (NIHON ITA GLASS K.K.) 09-04-1983

PATENTS ABSTRACTS OF JAPAN, Band 9, Nr. 227 (P-388)[1950], 13. September 1985; & JP-A-60 85 446 (ASAHI KOUGAKU KOGYO K.K.) (Kat. A) 14-05-1985

PATENTS ABSTRACTS OF JAPAN, Band 6, Nr. 152 (P-134)[1030], 12. August 1982; & JP-A-57 71 529 (TOKYO DENKI KAGAKU KOGYO K.K.) 04-05-1982

PATENTS ABSTRACTS OF JAPAN, Band 8, Nr. 269 (P-319)[1706], 8. Dezember 1984; & JP-A-59 135 635 (MATSUSHITA DENKI SAN-GYO K.K.) 03-08-1984

PATENTS ABSTRACTS OF JAPAN, Band 8, Nr. 282 (P-323)[1719], 22. Dezember 1984; & JP-A-59 148 152 (SEIKO DENSHI KOGYO K.K.) 24-08-1984

PATENTS ABSTRACTS OF JAPAN, Band 9, Nr. 312 (P-411)[2035], 7. Dezember 1985; & JP-A-60 140 548 (TOSHIBA K.K.) 25-07-1985

Erfinder: **Aerts, Erik Gerard**
**Groenewoudseweg 1**
**NL-5621 BA Eindhoven(NL)**
Erfinder: **v. Rosmalen, Gerard E. c/o Int. Octr.**
**Bureau B.V.**
**Prof. Holstlaan 6**
**NL-5656 AA Eindhoven(NL)**

(74) Vertreter: **Kupfermann, Fritz-Joachim, Dipl.-Ing. et al**
**Philips Patentverwaltung GmbH Wendenstrasse 35 Postfach 10 51 49**
**W-2000 Hamburg 1(DE)**

## Beschreibung

Die Erfindung bezieht sich auf eine Abtasteinheit zum Steuern und Richten eines Strahlungsbündels auf Aufzeichnungsspuren einer abzutastenden Oberfläche eines Informationsträgers, wobei die Abtasteinheit ein Objektiv mit einer optischen Achse aufweist, das mit einer Objektivlinse zum Fokussieren des Strahlungsbündels zu einem Abtastfleck auf der genannten Oberfläche versehen ist, wobei die Abtasteinheit weiterhin eine elektromagnetische Antriebsvorrichtung zum ständigen Korrigieren der Lage des Objektivs gegenüber dem Informationsträger aufweist, wobei die Antriebsvorrichtung mit einer Objektivhalterung für das Objektiv versehen ist, wobei diese Objektivhalterung einen koaxial zu der optischen Achse angeordneten, beweglichen ringförmigen Magnetkörper aus dauermagnetischem Material aufweist, der an den axialen Enden mit Magnetpolen versehen ist, wobei die Antriebsvorrichtung weiterhin mit ortsfesten Spulen versehen ist, die über einen Luftspalt mit dem genannten Magnetkörper magnetisch zusammenarbeiten und die mindestens drei Spulensätze aufweisen, wobei diese Sätze, in der Umfangsrichtung des Magnetkörpers gesehen, in untereinander gleichen Abständen nebeneinander angeordnet sind.

Eine derartige optische Abtasteinheit ist aus der EP-A-103 929 bekannt. Bei dieser bekannten Abtasteinheit ist das Objektiv in einer beweglichen, axial dauermagnetisierten Hülse mit zwei als magnetische Pole ausgebildeten axialen Enden befestigt. Die fest angeordneten Segmentspulen sind als flache, bananenförmig gebogene Spulen mit zwei gegenüber einander und gegenüber der genannten Hülse sich koaxial erstreckenden Spulenteilen ausgebildet, wobei bei Stromdurchgang durch die Segmentspulen der Strom in den betreffenden Spulenteilen in der entgegengesetzten Richtung geht.

Mit der bekannten Anordnung der Spulen lassen sich drei entsprechend den drei Koordinatenachsen eines orthogonalen Achsensystems gerichtete Kräfte sowie zwei um zwei der genannten Koordinatenachsen wirksame Drehmomente erzeugen.

Mit Hilfe der Antriebsvorrichtung der bekannten Abtasteinheit sind im Grunde alle erwünschten Bewegungen des Objektivs verwirklichbar. Diese Bewegungen umfassen eine axiale Bewegung, die parallel zu der optischen Achse des Objektivs verläuft und die zum Fokussieren eines Lichtfleckes eines Lichtbündels auf eine Informationsfläche einer sich drehenden optischen Platte dient, sowie zwei senkrecht zu aufeinander verlaufende radiale Bewegungen und/oder zwei Kippbewegungen um zwei senkrecht zueinander und zu der optischen Achse verlaufenden Achsen, wobei die letztgenannten vier Bewegungen zur radialen und tangentialen Spurfolge des Lichtflecks dienen.

Die bekannte Antriebseinheit weist jedoch den Nachteil auf, daß die magnetischen Kräfte zwischen den Spulen und der magnetischen Hülse als Funktion der axialen Verschiebung des Objektivs derart schwanken, daß bereits bei einer geringen axialen Verschiebung des Objektivs aus der Mitte zwischen den Spulensätzen liegenden Mittellage die Antriebsvorrichtung nicht mehr imstande ist, das Objektiv noch einwandfrei zu verschieben, um die erforderliche Fokussierung des Lichtbündels sowie die erforderliche Spurfolge des Lichtflecks zu verwirklichen. Die weit auseinander angeordneten Spulensätze eignen sich zwar dazu, sich über einen ausreichenden Abstand längs der optischen Achse zu bewegen; dabei nimmt aber die Möglichkeit, die anderen genannten Bewegungen zu erzeugen, so schnell ab, daß das Objektiv bereits in einem geringen Abstand von der Mittellage nicht mehr ausreichend angetrieben wird, um die Spurfolge des Lichtflecks gewährleisten zu können.

Die Erfindung hat nun zur Aufgabe, eine optische Abtasteinheit der eingangs erwähnten Art zu schaffen, die derart mit Spulen versehen ist, daß die zur Fokussierbewegung sowie die zur Spurfolge erforderlichen Kräfte beim über einen größeren Abstand Verschieben des Objektivs konstant oder nahezu konstant bleiben.

Die erfindungsgemäße optische Abtasteinheit weist dazu das Kennzeichen auf, daß jeder Spulensatz mit einer ersten Segmentspule versehen ist, die zwei sich im gleichen Abstand vom Magnetkörper, sich um diesen erstreckende, axial auseinanderliegende aktive Spulenteile aufweist, wobei diese Spulenteile sich je in der Nähe eines der axialen Enden des in der Mittellage befindlichen Magnetkörpers befinden, wobei die beiden genannten Spulenteile durch axial gerichtete weitere Spulenteile miteinander verbunden sind und wobei eine im wesentlichen axiale Bewegung bewirkbar ist, und daß in jedem Satz mindestens eine zweite Spule vorhanden ist, die sich wenigstens teiweise zwischen den aktiven Spulenteilen der genannten ersten Segmentspule befindet, wobei diese zweite Spule einen dem Magnetkörper zugewandten, sich in seiner Umfangsrichtung erstreckenden aktiven Spulenteil sowie einen weiter von dem Magnetkörper abliegenden Spulenteil aufweist, und wobei radiale Bewegungen bewirkbar sind.

Die erfindungsgemäße Abtasteinheit weist den Vorteil auf, daß bei Erregung der Spulen die axial sowie die radial gerichteten Kräfte, welche die Spulen auf den Magnetkörper ausüben, bei Verschiebung des Objektivs über einen Abstand, der weitgehend ausreicht zum Fokussieren und zum fokussiert Halten eines Lichtfleckes auf die Informationsfläche einer optischen Platte wenigstens nahezu konstant bleiben.

Ein weiterer Vorteil der erfindungsgemäßen Abtasteinheit ist der hohe Wirkungsgrad der Antriebsvorrichtung bei axialem Antrieb des Objektivs. Dieser hohe Wirkungsgrad ist eine Folge der günstigen Form und Ausrichtung der ersten Segmentspulen, wodurch weitgehend der größte Teil der ersten Segmentspulen der durch die beiden aktiven Spulenteile sich in Gebieten mit hoher magnetischer Feldintensität befindet.

Die Abtasteinheit nach der Erfindung weist weiterhin noch den Vorteil auf, daß die Objektivhalterung, wenigstens was die Baulänge anbelangt, gering sein kann. Dies ist von Bedeutung, weil eine flache Objektivhalterung es ermöglicht, den Schwerpunkt der Objektivhalterung mit dem Schwerpunkt des Objektivflansches zusammenfallen zu lassen, wodurch bei radialer Verschiebung des Objektivs unerwünschte Kippungen des Objektivs vermieden werden können.

Eine günstige Ausführungsform, die sich auf einfache Weise herstellen läßt und die ausreichende Ansteuerungsmöglichkeiten bietet, weist das Kennzeichen auf, daß in jedem der genannten Sätze zwei sich parallel zueinander erstreckende, als zweite Segmentspule ausgebildete zweite Spulen vorhanden sind, die, in axialer Richtung des Magnetkörpers gesehen, nebeneinander liegen, wobei Kippungen um zur axialen Richtung senkrechte Achsen bewirkbar sind.

Die obenstehend beschriebene erfindungsgemäße Spulenkonfiguration bietet die Möglichkeit, die zweite Segmentspule jedes Satzes zu erregen zum Verschieben des Objektivs in quer zu der optischen Achse stehenden Richtungen und weiterhin die erste Segmentspule jedes Satzes zu erregen zum an der optischen Achse entlang Verschieben des Objektivs. Die gesamten ersten Segmentspulen können erwünschtenfalls auch zum Kippen des Objektivs benutzt werden, und zwar um quer auf der optischen Achse stehende Achsen. Dies bedeutet, daß zum Fokussieren eines Lichtstrahles zu einem Lichtfleck auf einer Informationsfläche einer optischen Platte die ersten Segmentspulen der Antriebsvorrichtung angesteuert werden müssen und daß für die radiale und tangentiale Spurfolge des Lichtflecks die zweiten Segmentspulen angesteuert werden müssen, gegebenenfalls zusammen mit einer selektiven Ansteuerung der ersten Segmentspulen. Es sei bemerkt, daß die hier beschriebene Spulenkonfiguration durchaus verwendbar ist mit einem einfachen, axial magnetisierten Magnetkörper.

Eine andere Ausführungsform der Erfindung weist das Kennzeichen auf, daß jeder Spulensatz mit einer ersten Segmentspule versehen ist, die zwei sich im gleichen Abstand vom Magnetkörper, um diesen erstreckende, axial auseinanderliegende aktive Spulenteile aufweist, wobei diese Spulenteile sich je in der Nähe eines der axialen Enden des in der Mittellage befindlichen Magnetkörpers befinden, wobei die beiden genannten Spulenteile durch axial gerichtete weitere Spulenteile miteinander verbunden sind und wobei eine im wesentlichen axiale Bewegung bewirkbar ist, und daß in jedem der Sätze zwei sich, in axialer Richtung des Magnetkörpers gesehen, nebeneinander vorgesehene, als zweite Segmentspule ausgebildete zweite Spulen vorgesehen sind, wobei jede der zweiten Spulen zwei axial auseinander liegende aktive Spulenteile aufweist, von denen einer radial neben dem Magnetkörper liegt und durch zu dem Magnetkörper abgewinkelte weitere Spulenteile mit dem anderen aktiven Spulenteil verbunden ist, der sich axial gegenüber dem Magnetpol an einem der Enden des Magnetkörpers befindet, wobei radiale Bewegungen einschließlich von Kippungen um zur axialen Richtung senkrechte Achsen bewirkbar sind.

Die in dieser Ausführungsform vorhandenen zweiten Segmentspulen sind derart gebildet und gegenüber dem Magnetkörper ausgerichtet, daß weitaus der größere Teil dieser Segmentspulen in günstigen Gebieten des Magnetfeldes des Magnetkörpers liegt. Dadurch ist bei dem axialen sowie radialen Antrieb bei kleineren diametralen Abmessungen der Antriebsvorrichtung ein höherer Wirkungsgrad möglich.

Ausführungsbeispiele der Erfindung sind in der Zeichnung dargestellt und werden im folgenden näher beschrieben. Es zeigen:

Fig. 1 eine schematische Darstellung eines Teils der erfindungsgemässen Abtasteinheit,

Fig. 2 eine explodierte Ansicht einer ersten Ausführungsform der erfindungsgemässen Antriebsvorrichtung,

Fig. 3 eine Draufsicht der in Fig. 2 dargestellten Antriebsvorrichtung,

Fig. 4 einen Schnitt gemäss der Linie IV-IV in Fig. 2,

Fig. 5 eine explodierte Ansicht einer zweiten Ausführungsform der Antriebsvorrichtung der Abtasteinheit nach der Erfindung,

Fig. 6 einen Längsschnitt durch die in Fig. 5 dargestellte Antriebsvorrichtung.

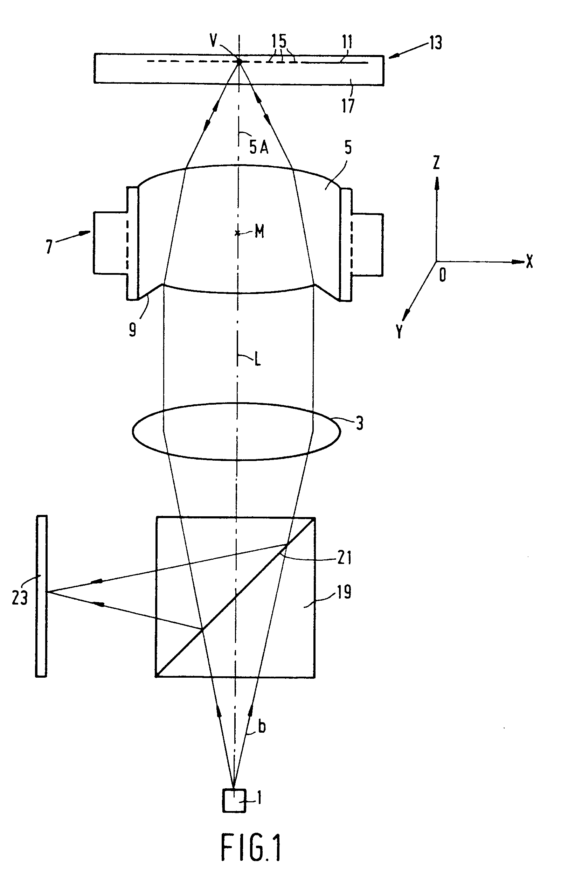

Die Abtasteinheit nach Fig. 1 ist mit einer Strahlungsquelle 1, beispielsweise einem Diodenläser, einer Kollimatorlinse 3 und einem Objektiv 5 mit einer optischen Achse 5A versehen, wobei das Objektiv in einer Objektivhalterung 7 einer noch näher zu beschreibenden elektromagnetischen Antriebsvorrichtung angeordnet ist. Die Kollimatorlinse 3 sowie das Objektiv 5 können mehrere Linselemente aufweisen, bestehen aber vorzugsweise aus einem einzigen Linsenelement mit mindestens einer asphärisch brechenden Oberfläche. In dieser Anordnung besteht das Objektiv aus nur einer Objektivlinse, die entsprechend einem Replika-Verfahren hergestellt wurde, wobei die Objektivlinse mit einem ringförmigen Spiegel 9 zwecks eines an dieser Stelle nicht näher beschriebenen Lagendetektionssystems versehen ist. Ein derartiges Lagendetektionssystem ist in der niederländischen Patentanmeldung 8501665 (PHN 11.416; hiermit durch Bezeichnung einbegriffen) eingehend beschrieben. Das von der Strahlungsquelle 1 gelieferte divergierende Strahlungsbündel b wird von der Kollimatorlinse 3 zu einem parallelen Bündel umgewandelt, das die Öffnung des Objektivs 5 auf einwandfreie Weise füllt. Das Objektiv fokussiert das Strahlungsbündel zu einem biegungsbegrenzten Strahlungsfleck V mit einem Druchmesser von beispielsweise 1 µm in der Informationsfläche 11 eines scheibenförmigen Informationsträgers 13, von dem in Fig. 1 ein kleiner Teil in radialem Schnitt dargestellt ist. Die Information ist in konzentrischen Spuren 15 oder quasi-konzentrischen Spuren, die zusammen eine spiralförmige Spur bilden, gegliedert. Die Information besteht aus einer Vielzahl optisch detektierbarer Informationsgebiete, zwischen denen Zwischengebiete liegen. Vorzugsweise befindet sich die Informationsfläche 11 in er Nähe der Oberseite des Informationsträgers 13, so dass das Bündel b durch das durchsichtige Substrat 17 des Informationsträgers geht, bevor es die Informationsfläche erreicht. Die Informationsfläche ist vorzugsweise strahlungsreflektierend, so dass das Bündel in der Richtung der Strahlungsquelle reflektiert wird.

Bei drehendem Informatinsträger ist das von der Informationsfläche reflektierte Bündel in der Zeite moduliert und zwarentsprechend der Folge von Informationsgebieten und Zwischengebieten in der auszulesenden Spur. Um das modulierte Bündel von dem von der Strahlungsquelle ausgestrahlten Bündel zu trennen, ist in dem Strahlungsweg ein Auskoppelelement 19 in Form beispeilsweise eines Teilprismas vorgesehen, dessen Trennfläche 21 mindestens einen Teil des zurückgeworfenen Bündels zu dem strahlungsempfindlichen Detektor 23 reflektiert. Der Detektor 23 verwandelt das modulierte Bündel in ein elektrisches Signal, das auf bekannte Weise zu einem Signal verarbeitet wird, das, abhängig von der Art der Information, die in dem Informationsträger gespeichert ist, dazu geeignet ist, sichtbar oder hörbar gemacht oder aber auf eine andere Art und Weise verarbeitet zu werden.

In dem rechten Teil der Fig. 1 ist ein Achsensystem XYZ angegeben, dessen Ursprung O als im Punkt M gedacht werden muss, so dass die Z-Achse mit dem Hauptstrahl L des Bündels b zusammenfällt. Die Z-Achse erstreckt sich in axialer Richtung, wobei dies die Richtung ist, in der das Objektiv verschoben werden muss, um das Bündel b zu dem Lichtfleck V zu fokussieren. Die X-Achse und die Y-Achse erstrecken sich in radialer Richtung bzw. in tangentialer Richtung gegenüber der Drehungsachse des Informationsträgers. Weil der Lichtfleck V den Spuren der sich drehenden Informationsplatte möglichst gut folgen soll, ist es notwending, dass das Objektiv 5 geradlinige Bewegungen entsprechend der X-Achse und der Y-Achse, sowie etwaige Drehungen um diese Achsen durchführen kann. Die Bewegung des Objektivs gemäss der Z-Achse wird auch als Fokussierbewegung bezeichnet. während die übrigen Bewegungen auch als Spurfolge- und Zeitfehlerkorrigierbewegungen bezeichnet werden.

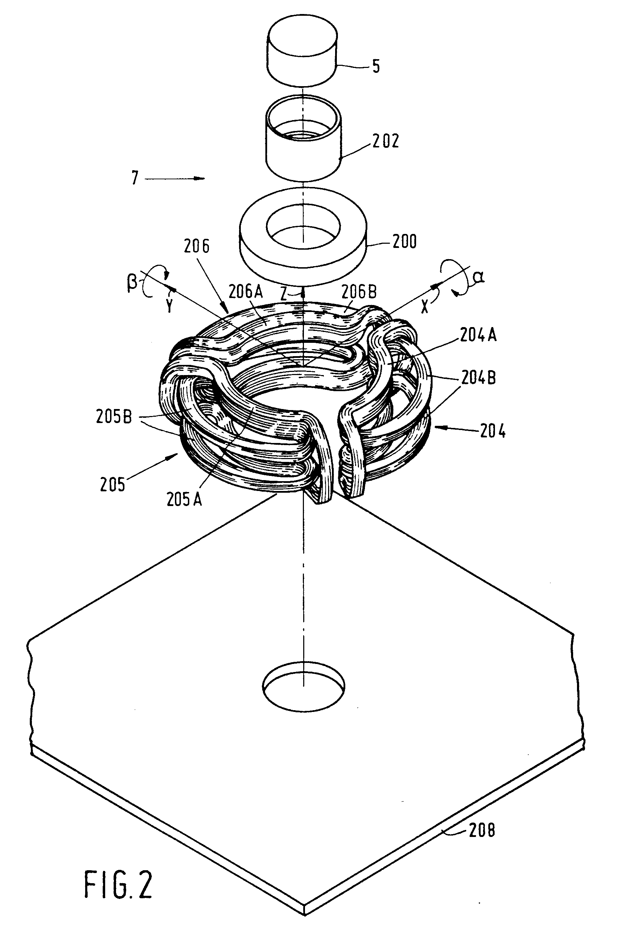

In den Fig. 2 bis 6 werden einige mögliche elektromagnetische Antriebsvorrichtungen der erfindungsgemässen Abtasteinheit näher beschrieben. Die Antriebsvorrichtungen bestehen im Grunde aus je einem beweglich aufgehängten ringformigen Magnetkörper und aus einer Anzahl von um denselben gegliederten ortsfesten Spulen, die entsprechend drei oder vier Sätze gegliedert sind. Der Magnetkörper ist ring- oder hülsenförmig und aus einem dauermagnetischen Werkstoff hergestellt. Die Spulen in den betreffenden Sätzen befinden sich in spezifischen Teilen des magnetischen Kraftfeldes des Magnetkörpers. Damit das Objektiv die bereits obenstehend beschriebenen gewünschten Bewegungen ohne parasitäre Resonanzen durchführen kann, ist das Objektiv in der genannten Antriebsvorrichtung magnetisch gelagert, wobei das Objektiv und die Objektivhalterung einerseits und die überigen Elemente der Abtasteinheit andererseits keinen körperlichen Kontakt haben.

Die Fig. 2, 3 und 4 zeigen eine Antriebsvorrichtung mit einem Magnetkörper 200, der axial magnetisiert ist, wie durch Pfeile in Fig. 4 angegeben ist, wodurch an den axialen Enden des Magnetkörpers 200 ein Südpol Z bzw. ein Nordpol N gebildet ist. Als Magnetwerkstoffe werden vorzugsweise Materialen mit einem hohen Energie-Inhalt wie Neodynium-Eisen-Bor und Samarium-Kobalt verwendet.

Der Magnetkörper 200 bildet zusammen mit einem Fassungsring 202 die Objektivhalterung 7 für das Objektiv 5. Um den Magnetkörper 200 herum gibt es eine Anzahl von Spulen auf einer Gestellplatte 208. Die betreffenden Spulen lassen sich in diesem Ausführungsbeispiel in drei Sätze von Spulen aufteilen und zwar bezeichnet durch 204, 205 und 206. Die Sätze 204, 205 und 206 sind, in der Umfangsrichtung des Magnetkörpers 200 gesehen, nebeneinander angeordnet und bilden zusammen einen mehr oder weniger geschlossenen Mantel um den Magnetkörper 200 herum.Statt drei Sätze können auch vier oder mehr als vier Spulensätze auf die dargestellte Art und Weise angeordnet sein. Jeder der Sätze 204, 205 und 206 ist mit einer ersten Segmentspule 204A, 205A bzw. 206A versehen, die derart gebildet und angeordnet ist, dass zwei aktive Spulenteile 204A1, 205A1, bzw. 206A1 der drei Segmentspulen sich nahe bei dem Magnetkörper 200 befinden und zwar in Gebieten, wo die magnetischen Feldlinien im wesentlichen radial gerichtet sind. Bei Erregung der Segmentspulen 204, 205, 206 können diese also eine sich längs der Z-Achse ergebende Magnetkraft auf den Magnetkörper ausüben, damit das Objektiv 5 zwecks der Fokussierung aus der in fig. 4 dargestellten Mittellage verschoben wird. Die genannten aktiven Spulenteile sind durch inaktive Spulenteile 204A2, 205A2 bzw. 206A2 paarweise miteinander verbunden.

Jeder der Sätze 204, 205 und 206 ist weiterhin mit zwei sich parallel zueinander erstreckenden zweiten Segmentspulen 204B, 205B bzw. 206B versehen. Diese Segmentspulen sind bananenförmiggebogen und sind mehr oder weniger in den genannten ersten Segmentspulen 204A, 205A, bzw. 206A angeordnet. Die zweiten Segmentspulen 204B, 205B und 206B weisen je einen dem Magnetkörper 200 zugewandten aktiven Spulenteil 204B1, 205B1 bzw. 206B1 auf, der sich in einem Teil des Magnetfeldes des Magnetkörpers 200 befindet, wo die Feldlinien sich im wesentlichen axial erstrecken. Die zweiten Segmentspulen können bei Stromdurchgang daher im wesentlichen radial gerichtete Magnetkräfte auf den Magnetkörper 200 ausüben, die bei bestimmten Kombinationen erregter Spulen Drehmomente bilden. Aus dem obenstehenden dürfte es einleuchten, dass durch selektive Ansteuerung der zweiten Magnetspulen 204B, 205B und 206B das Objektiv 5 längs der X-Achse und der Y-Achse verschoben wird, sowie um die X-Achse und die Y-Achse gekippt werden kann und zwar zwecks der bereits genannten Spurfolge und Zeitkorrektur beim Auslesen einer drehenden optischen Platte.

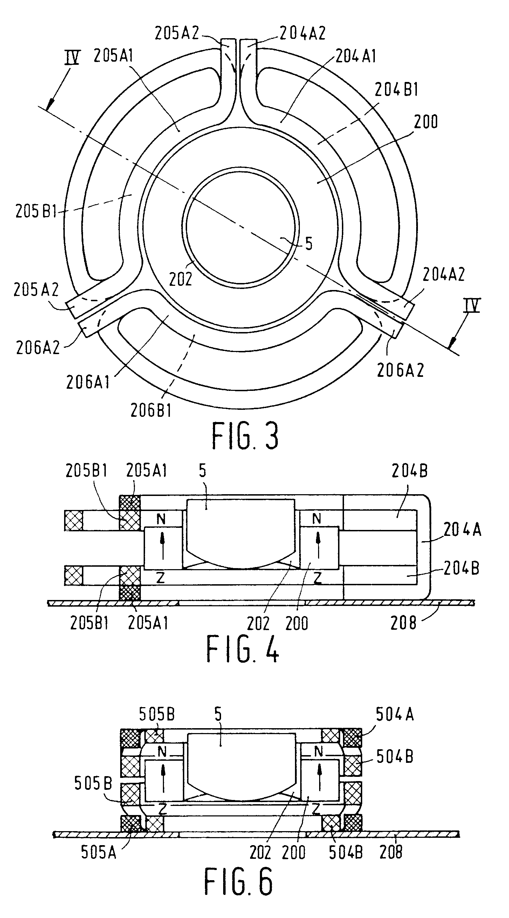

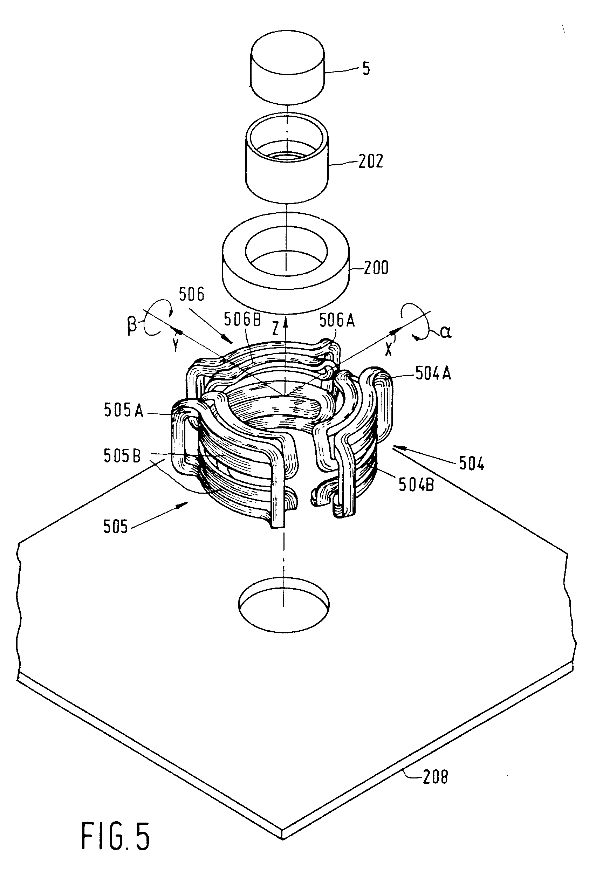

Die in den Fig. 5 und 6 dargestellte elektromagnetische Antriebsvorrichtung gleicht weitgehend der obenstehend beschriebenen Antriebsvorrichtung und wird deswegen nur beschränkt beschrieben. Die Antriebsvorrichtung ist wieder mit dem Magnetkörper 200 versehen, in dem die Fassung 202 mit dem Objektiv 5 befestigt ist und ist weiterhin mit drei Sätzen von Magnetspulen 504, 505 und 506 versehen, die auf die bereits beschriebenen Art und Weise um den Magnetkörper 200 angeordnet sind. Zur Befestigung der Spulen ist ein Gestell notwending, von dem auf schematische Weise die Gestellplatte 208 wiedergegeben ist. Jeder der Sätze 504, 505 und 506 besteht aus drei Segmentspulen und zwar einer ersten Segementspule 504A, 505A bzw. 506A und zwei zweiten Segmentspulen 504B, 505B bzw. 506B. Die ersten Segmentspulen 504A, 505A und 506A entspechen was die Form, die Lage und die Funktion anbelangt den ersten Segmentspulen 204A, 205A und 206A der obenstehend beschriebenen Ausführungsform und werden nicht näher beschrieben. Die beiden zweiten Segmentspulen 504B, 505B und 506B jedes der Sätze 504, 505 bzw. 506 liegen in der Fokussierungsrichtung gesehen hintereinander. Jede der Segmentspulen 504B, 505B und 506B sind mehr oder weniger flügelförmig gebogen oder gekrümmt und mit zwei aktiven Spulenteilen 504B1, 505B1 bzw. 506B1 versehen, die sich je in einem Gebiet des Magnetfeldes des Magnetkörpers 200 befinden, wo die Feldlinien sich im wesentlichen parallel zu der Z-Achse erstrecken. Die Form und die Ausrichtung der zweiten Segmentspulen 504B, 505B und 506B ermöglicht schnelle und sehr genau definierte Spurfolge- und Zeitkorrekturbewegungen des Objektivs, und zwar durch die geradlinige Bewegung längs sowie eine Drehung um die X-Achse und Y-Achse des Magnetkörpers 200.

Vollständigkeitshalber sei bemerkt, dass die Kippungen des Objektivs um die genannte X-Achse und Y-Achse durch eine Ansteuerung der ersten Segmentspulen, durch eine Ansteuerung zweiter Segmentspulen oder durch eine kombinierte Ansteuerung erster und zweiter Segmentspulen in den dargestellten Ausführungsformen herbeigefuhrt werden können.

**Patentansprüche**

1. Optische Abtasteinheit zum Steuern und Richten eines Strahlungsbündels auf Aufzeichnungsspuren einer abzutastenden Oberfläche eines Informationsträgers, wobei die Abtasteinheit ein Objektiv (5) mit einer optischen Achse aufweist, das mit einer Objektivlinse zum Fokussieren des Strahlungsbündels zu einem Abtastfleck auf der genannten Oberfläche versehen ist, wobei die Abtasteinheit weiterhin eine elektromagnetische Antriebsvorrichtung zum ständigen Korrigieren der Lage des Objektivs gegenüber dem Informationsträger aufweist, wobei die Antriebsvorrichtung mit einer Objektivhalterung für das Objektiv versehen ist, wobei diese Objektivhalterung einen koaxial zu der optischen Achse angeordneten, beweglichen ringförmigen Magnetkörper (200) aus dauermagnetischem Material aufweist, der an den axialen Enden mit Magnetpolen versehen ist, und wobei die Antriebsvorrichtung weiterhin mit ortsfesten Spulen versehen ist, die über einen Luftspalt mit dem genannten Magnetkörper magnetisch zusammenarbeiten und die mindestens drei Spulensätze (204 - 206) aufweisen, wobei diese Sätze, in der Umfangsrichtung des Magnetkörpers gesehen, in untereinander gleichen Abständen nebeneinander angeordnet sind, **dadurch gekennzeichnet,** daß jeder Spulensatz mit einer ersten Segmentspule (204A - 206A) versehen ist, die zwei sich im gleichen Abstand vom Magnetkörper, um diesen erstreckende, axial auseinanderliegende aktive Spulenteile (204A1 - 206A1) aufweist, wobei diese Spulenteile sich je in der Nähe eines der axialen Enden des in der Mittellage befindlichen Magnetkörpers befinden, wobei die beiden genannten Spulenteile durch axial gerichtete weitere Spulenteile miteinander verbunden sind und wobei eine im wesentlichen axiale Bewegung bewirkbar ist, und daß in jedem Satz mindestens eine zweite Spule (204B - 206B) vorhanden ist, die sich wenigstens teiweise zwischen den aktiven Spulenteilen der genannten ersten Segmentspule befindet, wobei diese zweite Spule einen dem Magnetkörper zugewandten, sich in seiner Umfangsrichtung erstreckenden aktiven Spulenteil (204B1 - 206B1) sowie einen weiter von dem Magnetkörper abliegenden Spulenteil aufweist und wobei radiale Bewegungen bewirkbar sind.

2. Optische Abtasteinheit nach Anspruch 1, **dadurch gekennzeichnet,** daß in jedem der genannten Sätze zwei sich parallel zueinander erstreckende, als zweite Segmentteile ausgebildete zweite Spulen vorhanden sind, die, in axialer Richtung des Magnetkörpers gesehen, nebeneinander liegen, wobei Kippungen um zur axialen Richtung senkrechte Achsen bewirkbar sind.

3. Optische Abtasteinheit zum Steuern und Richten eines Strahlungsbündels auf Aufzeichnungsspuren einer abzutastenden Oberfläche eines Informationsträgers, wobei die Abtasteinheit ein Objektiv (5) mit einer optischen Achse aufweist, das mit einer Objektivlinse zum Fokussieren des Strahlungsbündels zu einem Abtastfleck auf der genannten Oberfläche versehen ist, wobei die Abtasteinheit weiterhin eine elektromagnetische Antriebsvorrichtung zum ständigen Korrigieren der Lage des Objektivs gegenüber dem Informationsträger aufweist, wobei die Antriebsvorrichtung mit einer Objektivhalterung für das Objektiv versehen ist, wobei diese Objektivhalterung einen koaxial zu der optischen Achse angeordneten, beweglichen ringförmigen Magnetkörper (200) aus dauermagnetischem Material aufweist, der an den axialen Enden mit axial magnetisierten Magnetpolen versehen ist, wobei die Antriebsvorrichtung weiterhin mit ortsfesten Spulen versehen ist, die über einen Luftspalt mit dem

genannten Magnetkörper magnetisch zusammenmenarbeiten und die mindestens drei Spulensätze aufweisen, wobei diese Sätze, in der Umfangsrichtung des Magnetkörpers gesehen, in untereinander gleichen Abständen nebeneinander angeordnet sind, **dadurch gekennzeichnet,** daß jeder Spulensatz mit einer ersten Segmentspule (504A - 506A) versehen ist, die zwei sich im gleichen Abstand vom Magnetkörper, um diesen erstreckende, axial auseinanderliegende aktive Spulenteile aufweist, wobei diese Spulenteile sich je in der Nähe eines der axialen Enden des in der Mittellage befindlichen Magnetkörpers befinden, wobei die beiden genannten Spulenteile durch axial gerichtete weitere Spulenteile miteinander verbunden sind und wobei eine im wesentlichen axiale Bewegung bewirkbar ist, und daß in jedem der Sätze zwei sich, in axialer Richtung des Magnetkörpers gesehen, nebeneinander vorgesehene, als zweite Segmentspule ausgebildete zweite Spulen (504B - 506B) vorgesehen sind, wobei jede der zweiten Spulen zwei axial auseinander liegende aktive Spulenteile aufweist, von denen einer radial neben dem Magnetkörper liegt und durch zu dem Magnetkörper abgewinkelte weitere Spulenteile mit dem anderen aktiven Spulenteil verbunden ist, der sich axial gegenüber dem Magnetpol an einem der Enden des Magnetkörpers befindet, wobei radiale Bewegungen einschließlich von Kippungen um zur axialen Richtung senkrechte Achsen bewirkbar sind.

## Claims

1. An optical scanning unit for the control and alignment of a radiation beam on recording tracks of an information carrier surface to be scanned, the scanning unit comprising an objective (5) with an optical axis, which objective comprises an objective lens for focussing the radiation beam to form a scanning spot on said surface, the scanning unit further comprising an electromagnetic drive device for continually correcting the position of the objective relative to the information carrier, the drive device comprising an objective mounting for the objective, which objective mounting comprises a movable ring-shaped magnet body (200) made of a permanent-magnet material and arranged coaxially with the optical axis, which magnet body has magnet poles at its axial ends and the drive device further comprising stationary coils which cooperate magnetically with said magnet body via an air gap and which are arranged in at least three coil sets (204 - 206), which sets, viewed in the circumferential direction of the magnet body, are arranged side by side at equal distances from one another, characterised in that each coil set comprises a first segmental coil (204A - 206A) having two axially spaced active coil parts (204A1 - 206A1) situated equidistantly from and extending around the magnet body, which coil parts are each situated in the proximity of one of the axial ends of the magnet body when in its central position, said two coil parts being interconnected by axially directed further coil parts, enabling a substantially axial movement to be realised, and in that each set comprises at least a second coil (204B - 206B) situated at least partly between the active coil parts of said first segmental coils, which second coil comprises an active coil part (204B1 - 206B1) facing the magnet body and extending in its circumferential direction, and a coil part which is remote from the magnet body, enabling radial movements to be realised.

2. An optical scanning unit as claimed in Claim 1, characterised in that each of said sets comprises two second coils extending parallel to one another and constructed as second segmental parts, which coils are juxtaposed viewed in the axial direction of the magnet body, enabling pivotal movements about said axes perpendicular to the axial direction to be realised.

3. An optical scanning unit for the control and alignment of a radiation beam on recording tracks of an information carrier surface to be scanned, the scanning unit comprising an objective (5) with an optical axis, which objective comprises an objective lens for focussing the radiation beam to form a scanning spot on said surface, the scanning unit further comprising an electromagnetic drive device for continually correcting the position of the objective relative to the information carrier, the drive device comprising an objective mounting for the objective, which objective mounting comprises a movable ring-shaped magnet body (200) made of a permanent-magnet material and arranged coaxially with the optical axis, which magnet body has magnet poles at its axial ends, the drive device further comprising stationary coils which cooperate magnetically with said magnet body via an air gap and which are arranged in at least three coil sets, which sets, viewed in the circumferential direction of the magnet body, are arranged side by side at equal distances from one another, characterized in that each coil set comprises a first segmental coil (504A - 506A) having two axially spaced active coil parts situated equidistantly from and extending around the magnet body, which coil parts are each situated in the proximity of one of the axial ends of the magnet body when in its central position, said two coil parts being interconnected by axially directed further coil parts, enabling a substantially axial movement to be realised, and in that each set comprises two second coils (504B - 506B) arranged side by side viewed in the axial direction of the magnet body and constructed as second segmental coils, each of the second coils comprising two axially spaced active coil parts, of which one coil part is situated radially adjacent the magnet body and is connected to the other active coil part by further coil parts which are inclined relative to the magnet body, which other active coil part axially faces the magnet pole on one of the ends of the magnet body, enabling radial movements including pivotal movements about axes perpendicular to the axial direction to be realised.

## Revendications

1. Unité de balayage optique pour commander et diriger un faisceau de rayonnement vers des pistes d'enregistrement d'une surface d'un support d'information devant être balayée, dans laquelle l'unité de balayage présente un objectif (5) ayant un axe optique et muni d'une lentille d'objectif pour focaliser le faisceau de rayonnement en un spot de balayage sur ladite surface, l'unité de balayage présentant en outre un dispositif d'entraînement électromagnétique pour corriger de façon continue la position de l'objectif par rapport au support d'information, le dispositif d'entraînement étant muni d'un porte-objectif pour l'objectif, porte-objectif présentant un corps magnétique annulaire mobile (200) en matériau à aimantation permanente disposé coaxialement par rapport à l'axe optique et présentant des pôles magnétiques aux extrémités axiales, et le dispositif d'entraînement étant muni en outre de bobines stationnaires qui, à travers un entrefer, coopèrent magnétiquement avec ledit corps magnétique et qui présentent au moins trois jeux de bobines (204 à 206), jeux de bobines qui, vus dans le sens de la périphérie du corps magnétique, sont disposés à des intervalles égaux les uns à côté des autres, caractérisée en ce que chaque jeu de bobines est muni d'une première bobine en segment (204A à 206A) présentant deux parties de bobine actives (204A1 - 206A1) espacées axialement et s'étendant autour du corps magnétique tout en étant séparées d'une distance égale de celui-ci, parties de bobine qui sont situées chacune à proximité de l'une des extrémités axiales du corps magnétique se trouvant dans la position centrale, lesdites deux Parties de bobine étant reliées l'une à l'autre par des autres parties de bobine dirigées dans le sens axial, de façon à permettre un mouvement sensiblement axial, et en ce que, dans chaque jeu, est prévue au moins une deuxième bobine (204B - 206B) qui est située au moins partiellement entre les parties de bobine actives de ladite première bobine en segment, cette deuxième bobine présentant une partie de bobine active (204B1 - 206B1) s'étendant dans le sens de sa périphérie ainsi qu'une partie de bobine plus éloignée du corps magnétique de façon à permettre des mouvements radiaux.

2. Unité de balayage optique selon la revendication 1, caractérisée en ce que, dans chacun desdits jeux, sont prévues deux bobines parallèles réalisées sous la forme de deuxièmes bobines en segment qui, vues dans le sens axial du corps magnétique, sont situées l'une à côté de l'autre, de façon á permettre des mouvements de basculement autour d'axes perpendiculaires au sens axial.

3. Unité de balayage optique pour commander et diriger un faisceau de rayonnement vers des pistes d'enregistrement d'une surface d'un support d'information devant être explorée, dans laquelle l'unité de balayage présente un objectif (5) ayant un axe optique et muni d'une lentille d'objectif pour focaliser le faisceau de rayonnement en un spot de balayage sur ladite surface, l'unité de balayage présentant en outre un dispositif d'entraînement électromagnétique pour corriger de façon continue la position de l'objectif par rapport au support d'information, le dispositif d'entraînement étant muni d'un porte-objectif pour l'objectif, porte-objectif présentant un corps magnétique annulaire mobile (200) en matériau à aimantation permanente disposé coaxialement par rapport à l'axe optique et présentant des pôles magnétiques á aimantation axiale aux extrémités axiales, et le dispositif d'entraînement étant muni en outre de bobines stationnaires qui, à travers un entrefer, coopèrent magnétiquement avec ledit corps magnétique et qui présentent au moins trois jeux de bobines, jeux de bobines qui, vus dans le sens de la périphérie du corps magnétique, sont disposés à des intervalles égaux les uns à côté des autres, caractérisée en ce que chaque jeu de bobines est muni d'une première bobine en segment (504A à 506A) présentant deux parties de bobine actives espacées axialement et s'étendant autour du corps magnétique tout en étant séparées d'une distance égale de celui-ci, parties de bobine qui sont situées chacune à proximité de l'une des extrémités axiales du corps magnétique se trouvant dans la position centrale, lesdites deux parties de bobine étant reliées l'une à l'autre par des autres parties de bobine dirigées dans le sens axial, de façon à permettre un mouvement sensiblement axial, et en ce que, dans chacun des jeux sont prévues deux deuxièmes bobines (504B à 506B) réalisées sous la forme de deuxièmes bobines en segment et qui, vues dans le sens axial du corps magnétique sont disposées l'une à côté de l'autre, chacune des deuxièmes bobines présentant deux parties de bobine séparées dans le sens axial et dont une est située dans le sens radial à côté du corps magnétique et est reliée par d'autres parties de bobine, pliées vers le corps magnétique, à l'autre partie de bobine active située axialement en face du pôle magnétique à l'une des extrémités du corps magnétique de façon á permettre des mouvements radiaux, y compris des mouvements de basculement, autour d'axes perpendiculaires au sens axial.

FIG.1

FIG.2

FIG. 3

FIG. 4

FIG. 6

FIG.5

13